# EUROPÄISCHE PATENTANMELDUNG

(11) **EP 2 194 159 A1**
(43) Veröffentlichungstag der Anmeldung: **09.06.2010**
(21) Anmeldenummer: 09014058.3
(22) Anmeldetag: 10.11.2009
(51) Int. Cl.: C23C 14/35, H01J 37/34

(54) **PVD-Beschichtung mit schaltbarer Biasspannung**

(30) Priorität: 14.11.2008 DE 102008057286
(71) Anmelder: Systec System- und Anlagentechnik GmbH & Co. KG, 97753 Karlstadt (DE)
(72) Erfinder: Zufraß, Thorsten, 97762 Hammelburg (DE); Zänger, Sven, 74821 Mosbach (DE)
(74) Vertreter: Plate, Jürgen

(57) **Zusammenfassung**

Verfahren und Vorrichtung zum PVD-Beschichten von Substraten (2), wobei HIPIMS (High Power Impulse Magnetron Sputtering) in Verbindung mit einer negativen Biasspannung U_{B} an den Substraten (2) eingesetzt wird und eine Spannungsquelle (10) zum Anlegen der Biasspannung U_{B} beim Zünden einer Entladung an den Substraten (2) mittels einer Lasttrennschaltung (30) von den Substraten (2) galvanisch entkoppelt und beim Abklingen der Entladung wieder mit den Substraten (2) verbunden wird.

## Beschreibung

Die vorliegende Erfmdung betrifft ein Verfahren zum PVD-Beschichten von Substraten, wobei HIPIMS (High Power Impulse Magnetron Sputtering) in Verbindung mit einer negativen Biasspannung an den Substraten eingesetzt wird, sowie eine Vorrichtung zur Durchführung des Verfahrens.

Für die Erzeugung von dünnen Beschichtungen auf Substraten sind verschiedene Techniken bekannt. Diese können im wesentlichen zwei Gruppen zugeordnet werden, die als chemische (CVD) und physikalische Dampfphasenabscheidung (PVD) bezeichnet werden. Bei der CVD-Methode werden einer Beschichtungskammer gasförmige Reaktanten zugeführt, die miteinander reagieren und auf einem Substrat als dünner Film kondensieren. Damit eine chemische Reaktion stattfindet, muß die Temperatur nahe der Oberfläche des Substrates in der Regel in einem Bereich oberhalb von 1000 °C liegen. Die hohe Temperatur fördert die Diffusion der filmbildenden Reaktanten bzw. des Reaktionsproduktes in die Oberfläche des Substrates und verbessert die Haftung der dünnen Schicht. Allerdings ist hiermit der Nachteil verbunden, daß die homologe Temperatur, d.h. der Quotient aus Wachstums- und Schmelztemperatur häufig einen Wert um 0,8 annimmt. Dadurch kommt es in erhöhtem Maße zu Rekristallisation und damit verbunden Phasenumwandlung, welche die Schicht- und Oberflächeneigenschaften in nachteiliger Weise beeinflußen kann. Deshalb werden andere Methoden, wie Plasma-unterstützte CVD (PACVD) bevozugt. PACVD ermöglicht es, die Wachstums- bzw. Abscheidetemperatur auf Werte um 700 °C abzusenken, so daß Rekristallisationprozesse in verringertem Maße auftreten.

Bei der PVD-Methode liegt das Schichtmaterial zunächst in fester Form als sogenanntes Target vor. Das Target wir mittels verschiedener Methoden in die gasförmige Phase überfuhrt, insbesondere durch thermisches Verdampfen oder durch Sputtern (Zerstäuben), um hieran anschließend auf dem Substrat zu kondensieren. Im Gegensatz zu CVD ist es bei PVD möglich, das Substrat auf niedriger Temperatur weit unter dem Schmelzpunkt des Schichtmaterials zu halten. Somit kann mittels PVD das Schichtmaterial auch in einer amorphen metastabilen Phase abgeschieden werden.

Für die industrielle PVD-Beschichtung von Substraten mit funktionellen oder dekorativen Schichten verschiedenster chemischer Zusammensetzung hat sich die Sputtertechnik bewährt.

Beim Sputtern wird ein Füll- oder Sputtergas wie beispielsweise Argon bei niedrigem Druck im Bereich von 10⁻⁴ bis 0,1 mbar ionisiert. Die Ionisierung erfolgt durch Stöße zwischen Elektronen und Atomen des Sputtergases. Die positiv geladenen Ionen des Sputtergases werden durch ein negatives elektrisches Potential auf das Target der Sputterkathode zu beschleunigt und bombardieren dieses. Durch das Bombardement mit Ionen des Sputtergases werden Atome oder Atomcluster aus dem Targetmaterial herausgeschlagen. Ein Teil der abgesputterten Atome des Targets kondensiert auf Substraten, die in der Nähe des Targets angeordnet sind. Auf diese Weise entstehen sehr dünne Schichten des Targetmaterials auf den Substraten.

Die Eigenschaften von Sputterschichten, wie Haftung auf dem Substrat, Dichte und Mikrostruktur können durch ionisierte PVD (IPVD) in vorteilhafter Weise beeinflußt werden. Bei der IPVD-Methode werden die in die Gasphase überführten Atome des Targetmaterials ionisiert und mittels eines an das Substrat angelegten negativen Potentials, der sogenannten Biasspannung U_{B} auf das Substrat zu beschleunigt. Je nach Höhe der Biasspannung U_{B} und der Ladungsstufe der Targetionen (ein- bis mehrfach positiv), treffen die Targetionen mit mehr oder minder hoher kinetischer Energie auf das Substrat auf. Abhängig von der kinetischen Energie der Targetionen treten dabei folgende Wechselwirkungen auf:
- Implantation von Targetionen in die Oberfläche des Substrates (Ionenimplantation)
- Entfernung von Verunreinigungen von der Substratoberfläche (Ionenätzung)
- Stöße zwischen den Targetionen und den Atomen der Sputterschicht, wobei die Atome der Sputterschicht ihre Position wechseln und durchmischt werden (Ionenmischung)

Typischerweise wird die Biasspannung U_{B} auf einen Wert zwischen 0 und -1200 V eingestellt, bezogen auf die Wand der Beschichtungskammer bzw. auf Massepotential.

Magnetronsputtern (MS) stellt eine besonders effektive Art des Sputterns dar. Beim Magnetronsputtern werden in der Nähe des Targets ein zur Targetoberfläche parallel gerichtetes Magnetfeld und ein senkrecht gerichtetes elektrisches Feld erzeugt. Auf die durch das elektrische Feld beschleunigten Elektronen wirkt die magnetische Lorentzkraft, welche die Elektronen auf spiralförmige Bahnen lenkt. Dieser Vorgang wird auch als magnetischer Einschluß (magnetic confinement) bezeichnet. In dem Raumvolumen des magnetischen Einschlusses legt jedes Elektron eine lange Wegstrecke zurück, wobei es mit vielen Atomen des Sputtergases kollidiert. Hierdurch werden auch bei niedrigem Druck des Sputtergases besonders effektiv Ionen erzeugt. Zum Sputtern von leitfähigen Materialien (z.B. Wolfram-Target) oder reaktiven Komponenten (z.B. Silizium-Target und Stickstoff im Sputtergas zur Erzugung von Si₃N₄-Schichten) wird bevorzugt Gleichstrom-Magnetronsputtern (dcMS) eingesetzt. Typische Betriebsparameter für dcMS sind nachfolgend aufgelistet:

| **Betriebsparameter** | **Wert** |
|---|---|
| Kathodenpotential | -300 bis -1000 V |
| Magnetische Feldstärke | 0,1 bis 1 T |
| Gasdruck | 1 bis 10 mTorr |
| Target Stromdichte | 100 mA·cm⁻² |
| Target Leistungsdichte | 50 W·cm⁻² |

Im Stand der Technik werden für dcMS vorzugsweise unbalancierte Magnetronkathoden (LTBM) verwendet, um die Plasmazone vor dem Kathodentarget aufzuweiten. Bei einem unbalancierten Magnetron ist ein Teil der magnetischen Feldlinien nicht vor dem Kathodentarget geschlossen, sondern verläuft in Richtung des Beschichtungsraums, in welchem sich die Substrate befinden. Aufgrund dieser Feldkomponenten wird ein Teil der Elektronen in Richtung der Substrate geführt, so daß sich das Plasma zu den Substraten hin ausdehnt. Das hierfür erforderliche Magnetfeld wird typischerweise mittels einer elektromagnetischen Spule erzeugt, welche die hinter dem Kathodentarget angeordneten Permanentmagnete umgibt.

Einen Nachteil der dcMS stellt die geringe Ionisierung der Targetmaterialien im Bereich von wenigen Prozent dar. Um die Ionisierung zu erhöhen, müßte die elektrische Leistungsdichte an dem Target auf Werte gesteigert werden, bei denen die Temperatur an der Targetoberfläche trotz Einsatz effektiver Kühlmethoden den Schmelzpunkt überschreitet.

Grundsätzlich darf die zur Erzielung einer hohen Ionisierung der Targetmaterialien erforderliche Leistungsdichte am Target nur während kurzer Zeiten (transient) einwirken. Im Stand der Technik sind hierzu die Methode des Lichtbogen-Sputterns (Arc Sputtering) und des Hochleistungsimpuls-Sputterns bekannt.

Beim Lichtbogen-Sputtern wird das Targetmaterial durch eine Lichtbogenentladung mit im wesentlichen zeitlich konstanter elektrischer Leistung verdampft. Die Lichtbogenentladung ist auf einen kleinen Brennfleck beschränkt, der mit hoher Geschwindigkeit über die Targetoberfläche wandert bzw. gelenkt wird. Durch die schnelle Ablenkung des Brennflecks wird die Targetoberfläche lokal kurzzeitig aufgeschmolzen bzw. verdampft und das Targetmaterial hochgradig ionisiert. Allerdings weisen Lichbogenentladungen den Nachteil auf, daß durch die explosionsartige Verdampfung der Targetoberfläche mikroskopische Tröpfchen des Targetmaterials, sogenannte Droplets, auf dem Substrat deponiert werden. Diese Droplets wirken sich nachteilig auf die Schichteigenschaften aus.

Beim Hochleistungsimpuls-Sputtern werden dem Sputtertarget kurze Pulse mit sehr hoher elektrischer Leistung zugeführt. High Power Impuls Magnetron Sputtering (HIPIMS) stellt eine besonders geeignete Art der Hochleistungsimpuls-Sputterns dar und gewinnt zunehmend an industrieller Bedeutung. Das HIPIMS-Verfahren zeichnet sich durch eine impulsförmige Zufuhr der elektrischen Leistung auf das als Kathode wirkende Target aus. Aufgrund der der Kathode zugeführten hohen Leistungsdichte von typischerweise 1000 bis 3000 W·cm⁻² während einer Impulsdauer von 50 bis 1000 µs stellt sich eine Plasmakonfiguration ein, die abweichend von der für dcMS charakteristischen anomalen Glimmentladung, Ähnlichkeit mit einer Lichtbogenentladung aufweist. Bei dcMS beträgt die Ionisierung des gesputterten Targetmaterials nur wenige Prozent. Demgegenüber sind beim HIPIMS-Verfahren IonenKonzentrationen von über 50 % (im Falle von Titan als Sputtermaterial bis zu 90 %) erzielbar. Zudem tritt ähnlich wie bei der Lichtbogenentladung Mehrfachionisierung der Targetatome auf. Hierdurch ergeben sich für die Schichtbildung sehr günstige Bedingungen, die sich unter anderem in einer sehr hohen Dichte des abgeschiedenen Materials und in einer exzellenten Haftfestigkeit äußern.

Beim HIPIMS-Verfahren wird das Sputtertarget mit Hochspannungspulsen mit einer Pulshöhe von einigen hundert bis einigen tausend Volt und einem Lastfaktor von unter 1% betrieben. Der Lastfaktor bezeichnet das Verhältnis von Pulsdauer zu Pulsabstand (Pulsabstand = 1/Pulsfrequenz). Um eine Überheizung des Targets zu vermeiden, ist es notwendig, einen Lastfaktor unter 1 % einzuhalten, wodurch die Abscheiderate und damit die Produktivität des HIPIMS-Verfahrens um ein Vielfaches geringer ist als bei dcMS. Die auf die Targetfläche bezogene maximale Leistungsdichte der beim HIPIMS-Verfahren eingesetzten Pulse beträgt mehrere kW·cm⁻². Nach dem Aufschalten der Hochspannung auf das Target verstreicht eine Zeit von 15 bis 40 µm, bis das Plasma vor dem Target zündet und der Puls seine Maximalspannung erreicht. Nach dem Zünden des Plasmas kann es, abhängig von der Bauweise der elektrischen Energieversorgung, bis zu mehreren hundert Mikrosekunden, typischerweise zwischen 50 und 150 µs dauern, bis der Puls abklingt.

In industriell genutzten PVD-Beschichtungsanlagen, die für den Einsatz von dcMS und/oder HIPIMS konzipiert sind, dient in der Regel die Wand der Beschichtungskammer als Anode. Dementsprechend wird die Potentialdifferenz zwischen dem Kathodentarget und der Wand der Beschichtungskammer als Kathodenspannung oder -potential bezeichnet. Ebenso ist die an den Substraten anliegende Biasspannung U_{B} auf die Wand der Beschichtungskammer bezogen.

Bei dem Einsatz von HIPIMS in Verbindung mit einer negativen Biasspannung U_{B} werden an einzelnen Substraten lokalisierte Entladungen beobachtet. Durch diese Entladungen können die Substrate oder die mit dem Substratträger verbundene Spannungsquelle zum Erzeugen der Biasspannung U_{B} beschädigt werden.

Bei einer gegen Überspannung geschützten Spannungsquelle verursachen die voranstehend erwähnten Entladungen an den Substraten erhebliche Störungen; häufig wird die Spannungsquelle durch eine integrierte Sicherung ausgeschaltet. Um die Spannungsquelle weiter zu betreiben, ist es dann erforderlich, die Sicherung manuell oder elektronisch zurückzusetzen. Aufgrund dieses Problem ist bei der Beschichtung mittels HIPIMS die Biasspannung an den Substraten nicht konstant. Deshalb sind die vorteilhaften Effekte der Ionenätzung, Ionenimplantation und Ionenmischung, die auf der Beschleunigung von positiven Ionen des Targetmaterials durch die Biasspannung beruhen, nicht in vollem Umfang nutzbar, so daß lediglich suboptimale Homogenitäts- und Haftfestigkeitswerte erzielt werden.

Die vorliegende Erfmdung hat die Aufgabe, die Homogenität und Haftfestigkeit von Beschichtungen zu verbessern, die ganz oder teilweise mittels HIPIMS abgeschieden sind.

Erfindungsgemäß wird die voranstehende Aufgabe durch die Merkmale des Patentanspruchs 1 gelöst. Danach ist das in Rede stehende Verfahren zum PVD-Beschichten von Substraten, bei dem HIPIMS in Verbindung mit einer negativen Biasspannung U_{B} an den Substraten eingesetzt wird, dadurch gekennzeichnet, daß eine Spannungsquelle zum Anlegen der Biasspannung U_{B} beim Zünden einer Entladung an den Substraten selbsttätig von den Substraten galvanisch entkoppelt und beim Abklingen der Entladung wieder mit den Substraten verbunden wird.

In Weiterbildung des erfmdungsgemäßen Verfahrens wird die Spannungsquelle von den Substraten entkoppelt, wenn:
- der Betrag der Biasspannung U_{B} unter einen Wert von 500 V, bevorzugt 300 V, und insbesondere 200 V fällt;
- an den Substraten ein Strom mit einer Stromstärke von größer 1 A, bevorzugt größer 5 A, und insbesondere größer 10 A fließt;
- die elektrische Leistung einer Entladung an den Substraten einen Schwellwert im Bereich von 5 bis 1500 KW, bevorzugt 50 bis 500 KW, und insbesondere 50 bis 200 KW übersteigt.

Im Weiteren wird durch die Erfmdung eine Vorrichtung zur PVD-Beschichtung von Substraten mit den Merkmalen des Patentanspruchs 5 geschaffen. Die in Rede stehende Vorrichtung umfasst eine oder mehrere HIPIMS-Kathoden und eine Spannungsquelle zum Anlegen einer Biasspannung an die Substrate und ist **dadurch gekennzeichnet, daß** zwischen der Spannungsquelle und den Substraten eine Lasttrennschaltung mit einem elektrisch steuerbaren Leistungsschalter angeordnet ist. Der Leistungsschalter ist vorzugsweise als IGBT (Insulated Gate Bipolar Transistor) oder MOSFET (Metal Oxide Semiconductor Field Effect Transistor) ausgebildet. Insbesondere ist die Lasttrennschaltung mit einem Mikrocontroller, einer Strommeßeinrichtung und/oder einer Spannungsmeßeinrichtung ausgerüstet. Weiterbildungen der Erfmdung sind **dadurch gekennzeichnet, daß** zwischen der Spannungsquelle und der Lasttrennschaltung ein parallel zur Spannungsquelle geschalteter Kondensator angeordnet ist; daß zwischen der Spannungsquelle und der Lasttrennschaltung ein Widerstand und/oder eine Diode angeordnet ist; und daß zwischen der Spannungsquelle und der Lasttrennschaltung eine Spule und/oder eine Diode angeordnet ist.

In einer besonders bevorzugten Ausführungsform umfasst die erfindungsgemäße Vorrichtung neben HIPIMS-Kathoden eine oder mehrere UBM-Kathoden.

Im Folgenden wird die Erfmdung anhand von Figuren näher erläutert. Es zeigen in schematischer Darstellung:
- Fig. 1: eine PVD-Beschichtungsvorrichtung mit HIPIMS-Kathode und einer zwischen Substrat und Bias-Spannungsquelle angeordneten Lasttrennschaltung;
- Fig. 2: eine konventionelle Schaltungsanordnung zur Abschirmung der Bias-Spannungsquelle; und
- Fig. 3: eine Lasttrennschaltung mit Mikro-Controller.

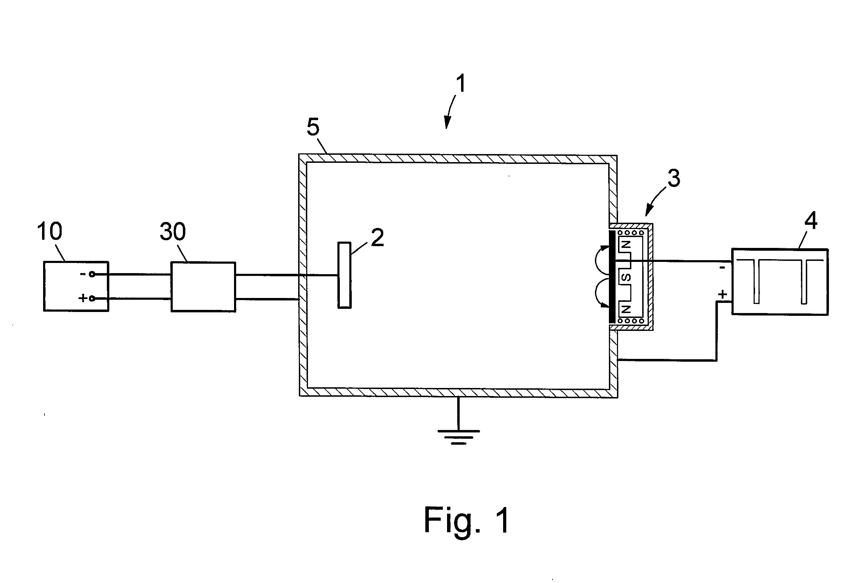

Fig. 1 zeigt eine erfindungsgemäße Vorrichtung 1 zur PVD-Beschichtung von Substraten 2. Die Vorrichtung 1 umfasst eine Beschichtungskammer 5 und eine oder mehrere HIPIMS-Kathoden 3. Die HIPIMS-Kathode 3 ist an eine Hochleitungsimpuls-Spannungsversorgung 4 angeschlossen. Das der HIPIMS-Kathode 3 in der Beschichtungskammer 5 gegenüberliegend angeordnete Substrat 2 ist an eine Spannungsquelle 10 angeschlossen. Mittels der Spannungsquelle 10 wird an das Substrat 2 eine negative Biasspannung angelegt von bis zu - 1200 V, bezogen auf die Beschichtungskammer 5 bzw. auf Massepotential. Zwischen dem Substrat 2 und der Spannungsquelle 10 ist eine Lasttrennschaltung 30 angeordnet, mittels derer die Spannungsquelle 10 vom Substrat 2 galvanisch entkoppelt werden kann.

In einer bevorzugten, in Fig. 1 nicht gezeigten Ausführungsform umfasst die Vorrichtung zusätzlich zu den HIPIMS-Kathoden eine oder mehrere UBM-Kathoden für den simultanen oder sequentiellen Einsatz von HIPIMS und dcMS. Um die Produktivität zu erhöhen, wird eine Vielzahl von Substraten gleichzeitig beschichtet. Hierzu werden die Substrate auf Substratträgern montiert, mittels derer die Substrate während des Beschichtungsvorgangs um eine oder mehrere Achsen rotierbar sind. Die Substratträger bestehen aus einem elektrisch leitfähigen Material und sind elektrisch leitend (mittels Kabeln) mit der Spannungsquelle 10 verbunden.

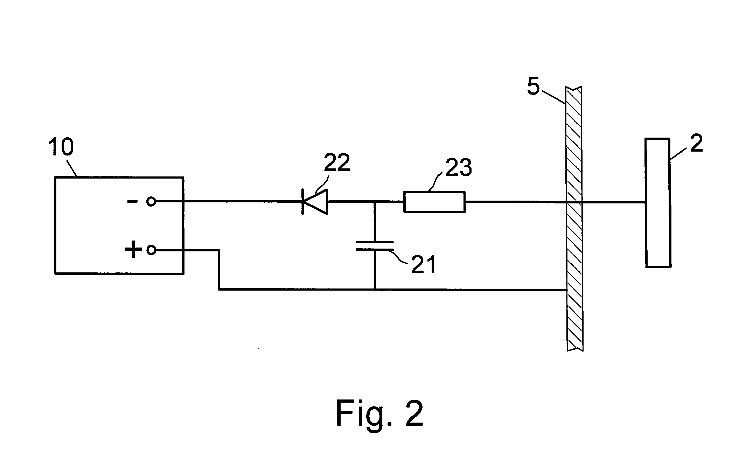

Fig. 2 zeigt ein Beispiel einer im Stand der Technik gebräuchlichen Schaltung zum Schutz der Spannungsquelle 10 vor elektrischen Entladungen an einem Substrat 2. Hierzu werden ein Kondensator 21 parallel und ein Widerstand 23 in Reihe zur Spannungsquelle 10 geschaltet nach Art eines RC-Tiefpaßfilters, wobei der Kondensator 21 als Puffer für hohe Impulsströme, wie sie bei einer Entladung auftreten, dient. Anstelle eines RC-Tiefpaßfilters kann auch ein RL-Tiefpaßfilter mit einer in Reihe geschalteten Induktivität (Spule) und einem parallel geschalteten Widerstand eingesetzt werden. Vorzugsweise wird eine Diode 22 zwischen den RC-Tiefpassfilter aus dem Widerstand 23 und dem Kondensator 21 derart geschaltet, daß sie einen Elektronenstrom vom Substrat 2 zur Spannungsquelle 10 sperrt.

In zahlreichen Fällen interferiert eine Schaltung der in Fig. 2 gezeigten Art mit der Funktion von Gleichstrom-Sicherungsschaltungen, wie sie in kommerziell verfügbaren Spannungsquellen 10 oftmals integriert sind, so daß ein stabiler Betrieb der Spannungsquelle 10 nicht möglich ist. Derartige Probleme können durch eine erfindungsgemäße Lasttrennschaltung behoben werden.

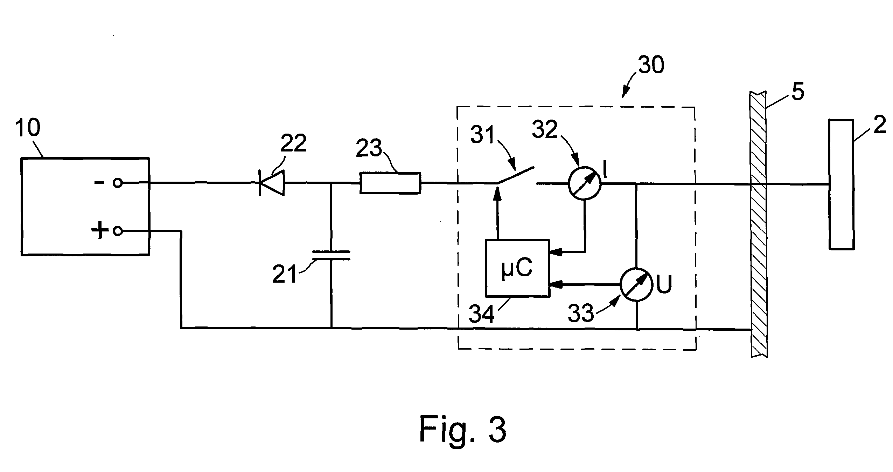

Fig. 3 zeigt ein Beispiel einer erfindungsgemäßen Lasttrennschaltung 30, die einen elektrisch steuerbaren Leistungsschalter 31, einen Mikrocontroller 34 sowie eine Strommeßeinrichtung 32 und/oder eine Spannungsmeßeinrichtung 33 umfasst. Vorzugsweise ist der Lastrennschalter 31 als IGBT (Insulated Gate Transistor) oder MOSFET (Metal Oxide Semiconductor Field Effect Transistor) ausgebildet, wobei das Ausgangssignal bzw. die Ausgabespannung des Mikrocontrollers 34 auf die Gate-Elektrode des IGBT/MOSFET aufgeschaltet ist. Als Eingabesignale für den Mikrocontroller 34 dienen die Ausgänge der Strommeßeinrichtung 32 und der Spannungsmeßeinrichtung 33. Der Mikrocontroller 34 ist derart programmiert, daß der Leistungsschalter 31 geöffnet wird, wenn die von der Strommeßeinrichtung 32 gemessene Stromstärke und/oder die an der Spannungsmeßeinrichtung 33 anliegende Spannung festgelegte erste Schwellwerte I_{S1} bzw. U_{S1} übersteigt. Analog hierzu schließt der Mikrocontroller den Leistungsschalter 31, wenn die an der Spannungsmeßeinrichtung 33 anliegende Spannung unter einen festgelegten zweiten Schwellwert U_{S2} fällt.

Wie in Fig. 3 dargestellt, kann die erfindungsgemäße Lastrennschaltung 30 wahlweise in Verbindung mit einer Schaltung gemäß Fig. 2, umfassend eine Diode 22 und/oder einen Widerstand 23 und/oder einen Kondensator 21, eingesetzt werden. Anstelle des Widerstands 23 kann auch eine Spule verwendet werden.

## Patentansprüche

1. Verfahren zum PVD-Beschichten von Substraten (2), wobei HIPIMS (High Power Impulse Magnetron Sputtering) in Verbindung mit einer negativen Biasspannung U_{B} an den Substraten (2) eingesetzt wird, **dadurch gekennzeichnet, daß** eine Spannungsquelle (10) zum Anlegen der Biasspannung U_{B} beim Zünden einer Entladung an den Substraten (2) selbsttätig von den Substraten (2) galvanisch entkoppelt und beim Abklingen der Entladung wieder mit den Substraten (2) verbunden wird.

2. Verfahren nach Anspruch 1, **dadurch gekennzeichnet, daß** die Spannungsquelle (10) von den Substraten (2) entkoppelt wird, wenn der Betrag der Biasspannung U_{B} unter einen Wert von 500 V, bevorzugt 300 V, und insbesondere 200 V fällt.

3. Verfahren nach Anspruch 1, **dadurch gekennzeichnet, daß** die Spannungsquelle (10) von den Substraten (2) entkoppelt wird, wenn an den Substraten (2) ein Strom mit einer Stromstärke von größer 1 A, bevorzugt größer 5 A, und insbesondere größer 10 A fließt.

4. Verfahren nach Anspruch 1, **dadurch gekennzeichnet, daß** die Spannungsquelle (10) von den Substraten (2) entkoppelt wird, wenn die elektrische Leistung einer Entladung an den Substraten (2) einen Schwellwert im Bereich von 5 bis 1500 KW, bevorzugt 50 bis 500 KW, und insbesondere 50 bis 200 KW übersteigt.

5. Vorrichtung (1) zur PVD-Beschichtung von Substraten (2), umfassend eine oder mehrere HIPIMS-Kathoden (3) und eine Spannungsquelle (10) zum Anlegen einer Biasspannung an die Substrate (2), **dadurch gekennzeichnet, daß** zwischen der Spannungsquelle (10) und den Substraten (2) eine Lasttrennschaltung (30) mit einem elektrisch steuerbaren Leistungsschalter (31) angeordnet ist.

6. Vorrichtung nach Anspruch 5, **dadurch gekennzeichnet, daß** die Lasttrennschaltung (30) einen Mikrocontroller (34) sowie eine Strommeßeinrichtung (32) und/oder eine Spannungsmeßeinrichtung (33) umfasst.

7. Vorrichtung nach Anspruch 5, **dadurch gekennzeichnet, daß** der Leistungsschalter (31) als IGBT (Insulated Gate Bipolar Transistor) oder MOSFET (Metal Oxide Semiconductor Field Effect Transistor) ausgebildet ist.

8. Vorrichtung nach Anspruch 5, **dadurch gekennzeichnet, daß** zwischen der Spannungsquelle (10) und der Lasttrennschaltung (30) ein parallel zur Spannungsquelle (10) geschalteter Kondensator (21) angeordnet ist.

9. Vorrichtung nach Anspruch 5 oder 8, **dadurch gekennzeichnet, daß** zwischen der Spannungsquelle (10) und der Lasttrennschaltung (30) ein Widerstand (23) und/oder eine Diode (22) angeordnet ist.

10. Vorrichtung nach Anspruch 5 oder 8, **dadurch gekennzeichnet, daß** zwischen der Spannungsquelle (10) und der Lasttrennschaltung (30) eine Spule und/oder eine Diode (22) angeordnet ist.

11. Vorrichtung nach Anspruch 5, **dadurch gekennzeichnet, daß** sie eine oder mehrere UBM-Kathoden aufweist.
